# EUROPEAN PATENT APPLICATION

(11) **EP 4 675 297 A1**
(43) Date of publication of application: **07.01.2026**
(21) Application number: 24306129.8
(22) Date of filing: 05.07.2024
(51) Int. Cl.: G01R 33/00, G01R 33/025

(54) **SENSOR INTEGRATION IN STRONG MAGNETIC ENVIRONMENT TECHNICAL FIELD**

(71) Applicant: Advanced Magnetic Interaction, AMI, 38170 Seyssinet-Pariset (FR)
(72) Inventor: Hautson, Tristan, 38170 Seyssinet-Pariset (FR); Pellerano, Vincent Thomas, 38170 Seyssinet-Pariset (FR)
(74) Representative: BIC

(57) **Abstract**

The present disclosure relates to a method (100) of magnetically calibrating a magnetometer sensing system (30) with respect to an electronic device (50), the method (100) comprising: detecting (110) a disturbing magnetic source (520) in the electronic device (50) relative to a reference coordinate system (X, Y, Z) of the magnetometer sensing system (30); identifying (120) one or more magnetometers (S_{k,l}) of the magnetometer sensing system (30) which are magnetically affected by the detected disturbing magnetic source (520); selecting (130) one or more balancing magnetic sources (400) to reduce a magnetic effect of the detected disturbing magnetic source (520) on the one or more identified magnetometers (S_{k,l}); and placing (140) the one or more selected balancing magnetic sources (400) in a fixed relation to the magnetometer sensing system (30) and/or to the disturbing magnetic source (520).

## Description

### TECHNICAL FIELD

The present disclosure relates to the technical field of magnetometer sensing systems, specifically to a method of magnetically calibrating a magnetometer sensing system with respect to an electronic device. More specifically, the present disclosure relates to electronic devices which comprise a magnetometer sensing system, wherein the magnetometer sensing system is calibrated according to the disclosed method. Furthermore, a system for determining a location of at least one user-borne device and which comprises the described electronic device is disclosed.

### BACKGROUND

In the technical field of location determination and/or tracking of a device held or worn by user (i.e., a user-borne device), the provision of a magnetometer sensing system (which includes a plurality of magnetometers) allows to measure a magnetic field associated with a magnetic object arranged in or coupled to the user-borne device. The user-borne devices using this technology may be electronically and/or electrically passive. More specifically, electrically passive means that the user-borne device may not comprise a power source (e.g., batteries) and/or means to receive power (e.g., wireless power transmission via an inductive coil) for powering an electronic feature of the user-borne device. Electronically passive means that no computation or processing occurs (or happens) on the user-borne device. The magnetometer measurements enable determining and/or tracking of the location of the magnetic object within a sensing volume created by the plurality of magnetometers. The location may include a position and/or orientation of the magnetic object. In some applications, the magnetic object may be arranged, for instance, within a writing device (e.g., a stylus) which may be operated by a user on a writing support during a user operation. Based on the magnetic field measurements associated with the magnetic object, a location of the writing device on the writing support may be determined which may subsequently be used (e.g., processed) to determine a writing and/or drawing.

Some approaches include the integration of the magnetometer sensing system, particularly the plurality of magnetometers, in an electronic device. That means the magnetometer sensing system is arranged at a fixed location relative the electronic device or at least at a fixed location relative to a device part of the electronic device. This enables the sensing volume to be in a predetermined and desired space relative to the electronic device. Drawbacks of integrating the magnetometer sensing system in an electronic device are a possible magnetic influence of magnetic sources (i.e., disturbing magnetic sources) at or in the electronic device which act with an unwanted magnetic field on the magnetometers. The presence of these disturbing magnetic sources may cause an offset (i.e., a deviation) on the magnetic field measurements or may even saturate one or more magnetometers of the plurality of magnetometers. If a magnetometer is saturated, it is no longer possible to get reliable magnetic field measurements. A saturated magnetometer is a magnetometer where the magnetic field measurements of which no longer increase if a magnetic object (e.g. of a user borne device) is moved closer to this magnetometer. When a magnetometer is saturated, it delivers a signal with a (known) measurement characteristic that is different from those liable to be delivered when it is not saturated. Even before a magnetometer is saturated a magnetometer may no longer operate in a linear area when a predetermined percentage of a maximum capacity of magnetic field strength (measurable by the magnetometer) is reached. In other words, an offset in the magnetic field measurements may result in the presence of the magnetic object. If the offset is significant, the operating range of the affected magnetometer will be reduced (particularly during use with a user borne device), and the affected magnetometer cannot be used properly. Some solutions suggest to relocate one or more magnetometers of the magnetometer sensing system and/or to relocate the disturbing magnetic source, such that the magnetic influence of the disturbing magnetic source on the magnetometer is eliminated or at least reduced. However, this may not always be feasible, e.g. due to spatial constraints of the electronic device. Furthermore, relocation approaches may compromise accuracy of tracking the user borne device.

The object of the present disclosure is to improve the accuracy of the location determination and/or tracking of a magnetic object based on magnetic field measurements obtained by a magnetometer sensing system which is integrated in an electronic device, and which is affected by a disturbing magnetic source.

### SUMMARY

The present disclosure relates to a method of magnetically calibrating a magnetometer sensing system with respect to an electronic device according to claim 1. Furthermore, the present disclosure relates according to claim 11 to an electronic device comprising a magnetometer sensing system which is calibrated with the method. According to claim 14, a system comprising the electronic device is disclosed. The dependent claims depict embodiments of the present disclosure.

According to a first aspect of the present disclosure, a method of magnetically calibrating a magnetometer sensing system with respect to an electronic device is provided. The method comprises detecting a disturbing magnetic source in the electronic device relative to a reference coordinate system of the magnetometer sensing system. The method further includes identifying one or more magnetometers of the magnetometer sensing system which are magnetically affected by the detected disturbing magnetic source. One or more balancing magnetic sources are selected to reduce a magnetic effect of the detected disturbing magnetic source on the one or more identified magnetometers. The one or more selected balancing magnetic sources is placed in a fixed relation to the magnetometer sensing system and/or to the disturbing magnetic source.

According to a second aspect of the present disclosure, electronic device for determining a location of at least one user-borne device which comprises at least one magnetic object is provided. The electronic device comprises a magnetometer sensing system, at least one disturbing magnetic source, and one or more balancing magnetic sources. The magnetometer sensing system includes at least one plurality of magnetometers. The at least one disturbing magnetic source is configured to generate a magnetic field having a magnetic effect on at least one magnetometer of the magnetometer sensing system. The one or more balancing magnetic sources are configured and arranged to reduce the magnetic effect on the at least one magnetometer. The magnetometer sensing system is magnetically calibrated according to the method of the first aspect.

According to a third aspect of the present disclosure, a system for determining a location of at least one user-borne device is provided. The system comprises at least one user-borne device comprising at least one magnetic object. The user borne device is operable with respect to an interaction surface of the system. The system further comprises an electronic device according to the second aspect. The magnetometer sensing system is configured to obtain magnetic field measurements associated with the at least one magnetic object.

In the context of this disclosure "magnetically calibrating" may be understood as reducing the magnetic influence of components, specifically functional components (for instance, a magnetic component of a speaker or a locking magnet), of the electronic device on the magnetometer sensing system. More specifically, the magnetometer sensing system is calibrated with respect to an electronic device the magnetometer sensing system is to be used with.

It should be understood that "a disturbing magnetic source in the electronic device" need not necessarily mean that the disturbing magnetic source is located inside the electronic device. The phrase may also encompass disturbing magnetic sources which are arranged at a surface, e.g., an outer surface, of the electronic device or a device part of the electronic device. Also, the phrase may encompass disturbing magnetic sources which are arranged on or in an auxiliary device of the electronic device (in a fixed location or fixed location range to the electronic device).

In the context of this disclosure a "disturbing magnetic source" can be understood as a source which causes a significant magnetic field on the magnetometer. Specifically, it should be noted that the "disturbing magnetic source" may be a physical disturbing magnetic source or a theoretical disturbing magnetic source. A theoretical disturbing magnetic source may describe an assumed magnetic source equivalent to a physical magnetic source of an associated magnetic field detectable/acting on a magnetometer. For instance, two separate physical magnetic sources may both magnetically affect one magnetometer. The separate magnetic fields of these two physical magnetic sources may interfere each other and lead to a resulting magnetic field which is detectable/acting on the magnetometer. This resulting (disturbing) magnetic field may be associated with one theoretical disturbing magnetic source. Thus, a "disturbing magnetic source" is not necessarily to be understood as one physical entity but can be understood as the assumed origin of the resulting disturbing magnetic field of two or more physical disturbing magnetic sources. If a "disturbing magnetic source" causes a significant magnetic field on the magnetometer may be expressed as a percentage of a full operating scale of the magnetometer of the magnetometer sensing system which is to be used with the electronic device (for example 10% of the full scale). A full operating scale may be defined as a value which causes the magnetometer to be saturated. In some embodiments, a magnetic source may be defined as a "disturbing magnetic source" when it causes a magnetic field of 5% to 50% of the full operating scale, specifically of 10% to 30% of the full operating scale, more specifically 20% +/-5% of the full operating scale.

In the context of the present disclosure a "balancing magnetic source" may be understood as an additional component which is added (to the electronic device) in order to reduce the magnetic influence of other electronic device components (specifically, disturbing magnetic sources) on the magnetometer sensing system. Structurally a "balancing magnetic source" can be understood as a source of a magnetic field, e.g., a permanent magnet.

### BRIEF DESCRIPTION OF THE DRAWINGS

Other characteristics will be apparent from the accompanying drawings, which form a part of this disclosure. The drawings are intended to further explain the present disclosure and to enable a person skilled in the art to practice it. However, the drawings are intended as non-limiting examples. Common reference numerals on different figures indicate like or similar features.
- **Fig. 1**: is a schematic view of a system for determining a location of at least one user-borne device according to a third aspect of the present disclosure including an electronic device according to the second aspect of the present disclosure;
- **Figs. 2a and 2b**: show a schematic top view and a detailed view of a corresponding side view of an electronic device according to the second aspect of the present disclosure;
- **Fig. 3**: is a schematic view of a plurality of magnetometers arranged in rows and columns with respect to a magnetometer body;
- **Figs. 4a to 4c**: show exemplary embodiments of the present disclosure wherein one balancing magnetic source is placed at locations different from that of the disturbing magnetic source;
- **Figs. 5a and 5b**: show exemplary embodiments of the present disclosure wherein one balancing magnetic source is placed at substantially the same location as the disturbing magnetic source;
- **Figs. 6 and 7**: show exemplary embodiments of the present disclosure wherein multiple balancing magnetic source are placed to reduce the magnetic effect of the detected disturbing magnetic source;
- **Fig. 8**: schematically illustrates a graph representing the operational areas of a magnetometer with the theoretical magnetic field on the x-axis and the measured magnetic field on the y-axis;
- **Fig. 9**: schematically illustrates a process flow diagram of the method of magnetically calibrating a magnetometer sensing system with respect to an electronic device according to the first aspect of the present disclosure;
- **Fig. 10**: schematically illustrates the method according to the first aspect of the present disclosure in more detail.

### DETAILED DESCRIPTION

Embodiments of the method of magnetically calibrating a magnetometer sensing system with respect to an electronic device, the electronic device and the system for determining a location of a user-borne device according to the present disclosure will be described in reference to the drawings as follows.

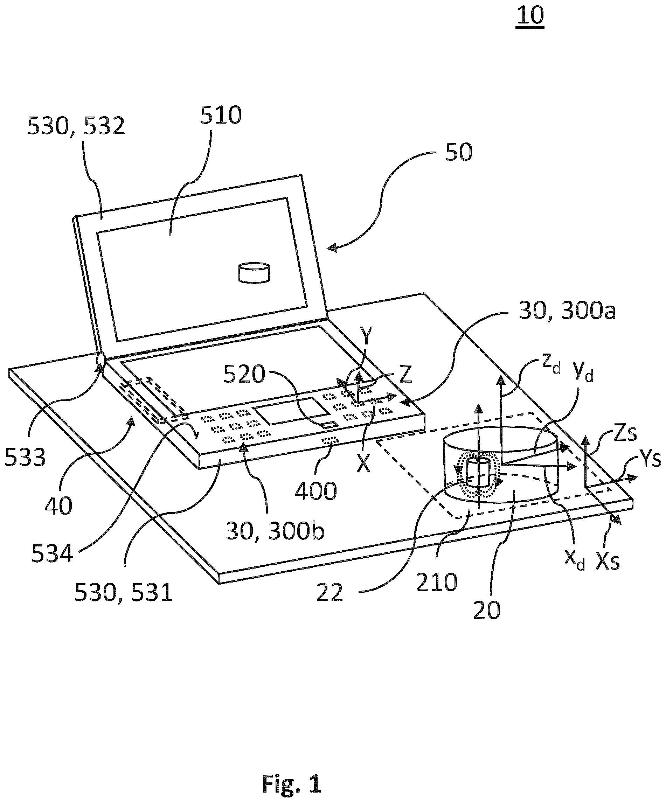

**Fig. 1** schematically illustrates a system 10 for determining a location of at least one user-borne device 20 is provided. The system comprises an electronic device 50 according to the second aspect of the present disclosure, and at least one user-borne device 20. In the exemplary configuration according to Fig. 1, the user-borne device 20 is a dial. In other embodiments, the user-borne device 20 may be a computer mouse, a keyboard, a ring, a toy, an eraser, a stylus, a joystick, or a brush. The user-borne device 20 comprises at least one magnetic object 22. Specifically, the at least one user-borne device 20 may be electrically and/or electronically passive (e.g., the magnetic object 22 may be a permanent magnet). The electronic device 50 is configured for determining a location of the at least one user-borne device 20 (specifically, its magnetic object 22). The electronic device 50 comprises a magnetometer sensing system 30. As shown in the exemplary configuration of Fig. 1, the magnetometer sensing system 30 comprises a first plurality of magnetometers 300a, and a second plurality of magnetometers 300b. However, it should be understood, that in other embodiments, the magnetometer sensing system 30 may also include only one or more than two pluralities of magnetometers 300 (which may in some embodiments be arranged at the same or different locations than those shown in Fig. 1). The plurality of magnetometers 300, 300a, 300b may be arranged directly in a device body 530 of the electronic device 50 or they may be arranged at a magnetometer body 320 which is arranged in or at the electronic device 50.

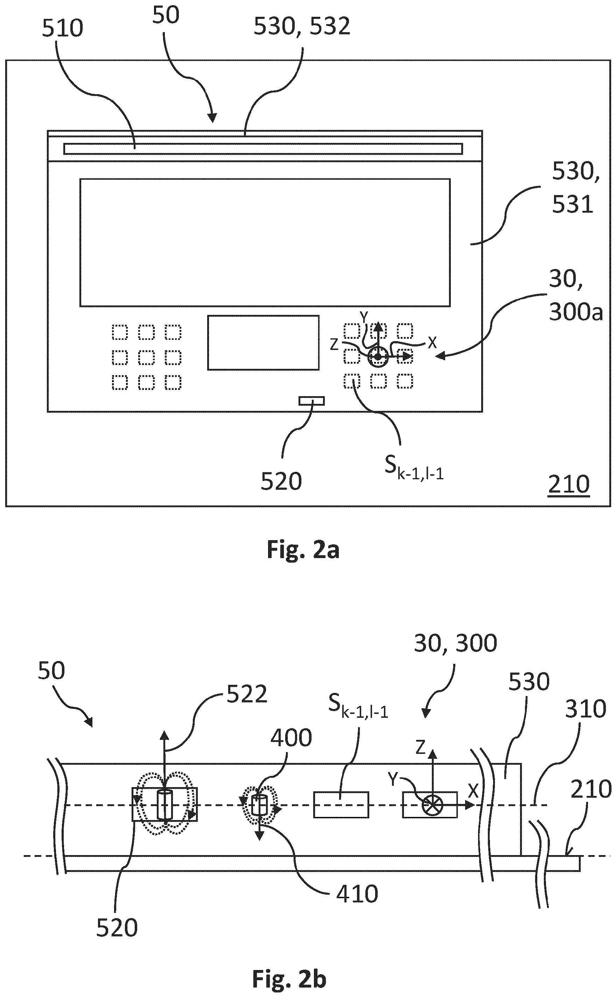

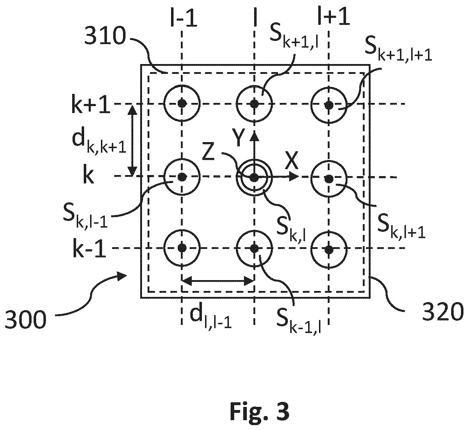

The plurality of magnetometers 300, 300a, 300b are configured to create a sensing volume. Specifically, the magnetometers S_{k,l} may be tri-axis magnetometers S_{k,l}. A tri-axis magnetometer S_{k,l} is a magnetometer S_{k,l} able to measure the projection of the magnetic field on three non-collinear measuring axes. Such a magnetometer S_{k,l} measures the direction of the magnetic field. In addition, generally, this magnetometer S_{k,l} also measures the amplitude or the norm of the magnetic field. The plurality of magnetometers 300 may be associated with a magnetometer plane 310 (see, **Figs. 2b****,** **3**). More specifically, the magnetometer plane 310 may be defined by a plane that may extend through a majority of the plurality of magnetometers 300. As shown particularly in Figs. 1 and 3, the magnetometer sensing system 30 may define a reference coordinate system XYZ. The plurality of magnetometers 300 may be associated with the reference coordinate system XYZ. The system 10 is configured to define the reference coordinate system XYZ relative to the plurality of magnetometers 300. The reference coordinate system XYZ may comprise a first reference axis X, a second reference axis Y and a vertical reference axis Z. The first reference axis X and the second reference axis Y may be orthogonal to each other. The vertical reference axis Z may be orthogonal to the first reference axis X and the second reference axis Y. The vertical reference axis Z may extend through a center of the plurality of magnetometers 300. In embodiments, the first reference axis X and the second reference axis Y may be defined on the magnetometer plane 310. In this case, the vertical reference axis Z may be orthogonal to the magnetometer plane 310.

Referring to **Fig. 3****,** an arrangement of the plurality of magnetometers with respect to a magnetometer body 320 is shown. In the embodiment shown in Fig. 3, the plurality of magnetometers 300 may be arranged in rows and columns. However, it is also possible that the plurality of magnetometers 300 may be arranged in an unordered manner within magnetometer body 320 and/or within the device body 530 of the electronic device 50 (this may be affected by the available space within the electronic device 50). A location calibration procedure (which is different from the "magnetic calibration") may be used to determine the exact locations and measurement axes of each magnetometer S_{k,l} within the electronic device 50 (and/or within the magnetometer body 320) relative to the reference coordinate system X, Y, Z. The plurality of magnetometers 300 are shown in Fig. 3 as being arranged in the magnetometer plane 310 (i.e., in the same plane relative to the vertical measurement reference axis Z). However, as outlined above, one or more of the magnetometers S_{k,l} may be distanced to the magnetometer plane 310, more specifically distanced in the direction of the vertical measurement reference axis Z. In the arrangement of Fig. 3, the plurality of magnetometers 300 may be arranged in rows k and columns l. Each magnetometer S_{k,l} may comprise a vertical magnetometer axis (e.g., Z) which may be arranged on the intersections of the rows k and columns l. Specifically, the barycenter of all three measurement axes of a magnetometer may be placed at the intersection of rows and columns. Adjacent magnetometers S_{k,l}, S_{k,l+1}, S_{k,l-1} may be separated along a row k by a distance d_{l,l+1} and d_{l,l-1}. Adjacent magnetometers S_{k,l}, S_{k+1,l}, S_{k-1,l} may be separated along a column 1 by a distance d_{k,k+1} and d_{k,k-1}. As outlined above, the distances dₖ, di between the respective magnetometers S_{k,l} may be equal or may differ.

With further reference to **Fig. 1****,** the electronic device 50 is a laptop computer. In other embodiments, the electronic device 50 may be or comprise a notebook, a smartphone, a screen, a board or a tablet. The electronic device 50 of Fig. 1 comprises a device body 530. The device body 530 a first device part 531 and a second device part 532. The first and second device parts 531, 532. In other embodiments, the electronic device 50 may comprise only one or more than two device parts. Device parts may also include auxiliary devices which are arranged in a fixed location relative to the electronic device (e.g., an auxiliary device plugged into a connector of the electronic device 50 such that the auxiliary device is arranged at a fixed location or location range relative to the electronic device). The first device part 531 and the second device part 532 may be rotatably coupled via a hinge 533. The second device part 532 may comprise an output device 510. The output device 510 may comprise a display or a screen. The first device part 531 may comprise a keyboard. As mentioned above, the magnetometer sensing system 30 is arranged in the device body 530, specifically in the first device part 531, of the electronic device 50. In other embodiments, the magnetometer sensing system 30 or at least one of its plurality of magnetometers 300, 300a, 300b may be arranged in the second device part 532. For instance, at least one plurality of magnetometers 300 may be arranged laterally and/or behind the display or the screen. Specifically, the plurality of magnetometers 300, 300a, 300b is arranged in a fixed location relative to the device body 530 or relative to a device part 531, 532 of the electronic device 50.

As shown in **Fig. 1****,** the at least one user-borne device 20 may be operable within the sensing volume created by the plurality of magnetometers 300, 300a, 300b. Specifically, the at least one user-borne device 20 may be operable with respect to an interaction surface 210. More specifically, the vertical interaction reference axis Zs of the interaction reference coordinate system Xs, Ys, Zs may be orthogonal to the interaction surface 210. In embodiments, the first interaction reference axis Xs and the second interaction reference axis Ys may be defined on the interaction surface 210. The first device part 531 may comprise a top surface 534. In some embodiments, the interaction reference coordinate system Xs, Ys, Zs may be defined on the top surface 534. In some embodiments, the vertical interaction reference axis Zs may be orthogonal to the first device part 531, more specifically to the top surface 534.

The system 10 is configured to track location and/or a movement of the at least one magnetic object 22 in at least five degrees of freedom.

In detail, the magnetometer sensing system 30 (detected via the plurality of magnetometers 300) is configured to obtain magnetic field measurements which are indicative of a magnetic field associated with the at least one magnetic object 22. The electronic device 50 may comprise or may be connectable to a processing unit 40. The processing unit 40 may be configured determine a user-borne device location. Specifically, the processing unit 40 may be configured to determine an absolute magnetic object location indicative of an absolute magnetic object position and/or an absolute magnetic object orientation of the at least one magnetic object 22 relative to the reference coordinate system X, Y, Z. More specifically, the absolute magnetic object location may be determined based on obtained magnetic field measurements. The processing unit 40 may be configured to generate magnetic field measurement data based on obtained magnetic field measurements. The magnetic field measurement data is indicative of a magnetic moment vector of the at least one magnetic object 22 relative to the reference coordinate system X, Y, Z. The magnetic moment vector may be indicative of a magnetic field orientation (in other words the direction of the magnetic field) and a magnetic field strength (in other words the amplitude or norm of the magnetic field). In Fig. 1, the magnetic moment vector of the magnetic object 22 is schematically indicated by the arrow emerging upwardly from the magnetic object 22 parallel to axis Z.

The processing unit 40 may be configured to determine the absolute magnetic object location by processing magnetic field measurement data to relate magnetic field measurement data to an absolute magnetic object location. In more detail, the absolute magnetic object location may include a magnetic object moment vector and/or a magnetic object position vector associated with the at least one magnetic object 22. In examples the magnetic field measurement data may originate from an asymmetrical magnetic field associated with the at least one magnetic object 22, expressed in a quaternion or three-dimensional matrix. The magnetic object moment vector may be indicative of a magnetic object orientation and a magnetic field strength of the at least one magnetic object 22 as mentioned above. The magnetic object position vector may be indicative of a magnetic object position with respect to the reference coordinate system X, Y, Z. Based on the absolute magnetic object location and geometric parameters of the user borne device 20 and a location of the at least one magnetic object 22 with respect to the user borne device 20 (more specifically with respect to the user borne device axes x_{d}, y_{d}, z_{d}), a user borne device location may be obtained.

Based on a location of the interaction surface 210 with respect to the reference coordinate system X, Y, Z a location of the user borne device 20 with respect to the interaction surface 210, more specifically the interaction reference coordinate system Xs, Ys, Zs may be obtained. During a user operation, the system 10 may be configured to track a movement of the at least one user borne device 20 relative to the interaction surface 210 over a time period. The movement or a representation of the movement may be outputted on the output device 510.

As shown in **Figs. 1****,** **2a and 2b****,** the electronic device 50 comprises at least one disturbing magnetic source 520. The exemplary illustrated disturbing magnetic source 520 may be a magnetic lock. The magnetic lock may be arranged at or close to the top surface 534 as shown. However, in other embodiments, the disturbing magnetic source 520 may be arranged at another fixed location with respect to the electronic device 50. Also the at least one disturbing magnetic source 520 may be another magnetic source than a magnetic lock. The at least one disturbing magnetic source 520 may comprise or be comprised in at least one of a speaker, a fan and/or a magnetic lock. Although it is referred to only one disturbing magnetic source 520 in the following explanations, in other embodiments, at least two, at least three or more (physical) disturbing magnetic sources 520 may be comprised in the electronic device 50. However, as mentioned above, magnetic fields of two or more disturbing magnetic sources will interfere each other and lead to a resulting disturbing magnetic field. A single magnetometer may be (magnetically) affected by the resulting disturbing magnetic field. Therefore, when more than one physical disturbing magnetic source is present, a magnetic effect of a resulting (disturbing) magnetic field (of a theoretical disturbing magnetic source) on a single magnetometer may be determined. As particularly visible in **Fig. 2b****,** the disturbing magnetic source 520 may be arranged substantially in the magnetometer plane 310. "Substantially in the magnetometer plane" may include positions within a close range about the magnetometer plane 310. The "close range" may include position within 2cm above and/or below, specifically within 0,5cm above and/or below, and more specifically within 0,25cm above and/or below the magnetometer plane 310. As mentioned above, the disturbing magnetic source 520 is arranged in a fixed location relative to the device body 530 or a device part 531, 532 of the electronic device 530. The at least one disturbing magnetic source 520 is configured to generate a magnetic field having a magnetic effect on at least one magnetometer S_{k,l} of the magnetometer sensing system 30. As mentioned above, a "disturbing magnetic source 520" may be defined as such when it affects a magnetometer S_{k,l} with a significant magnetic field. It may be expressed as a percentage of a full operating scale of the magnetometer (for example 10% of the full scale). A full operating scale may be defined as a magnetic strength value (measured in µT) which causes the magnetometer to be saturated (see, theoretical saturation threshold 612 explained below). As further mentioned above, a "disturbing magnetic source" may be a physical disturbing magnetic source or a theoretical disturbing magnetic source (comprised of two or more physical disturbing magnetic sources).

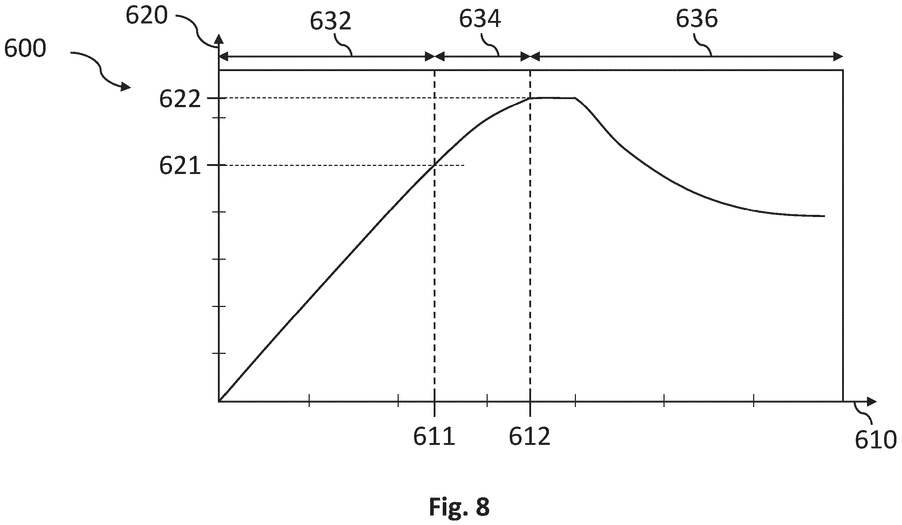

In this regard, **Fig. 8** schematically illustrates a graph 600 (also referred to as magnetometer operation curve 600) representing the operational area of a magnetometer. The x-axis describes the theoretical magnetic field 610 which acts on the magnetometer (linear scale, increasing from zero rightwardly, e.g., in [µT]). The y-axis describes the measured magnetic field 620, i.e., what the magnetometer actually measures (linear scale, increasing from zero upwardly, e.g., in [µT]). As shown in **Fig. 8****,** the magnetometer operation curve 600 comprises mainly three areas, a linear area 632, a non-linear area 634, and a saturation area 636. Starting from the origin, with an increasing theoretical magnetic field 610, the measured magnetic field 620 increases linearly until a first theoretical threshold 611 (and corresponding first measured threshold 621) is reached. Until this first theoretical threshold 611 any measured magnetic field 620 equals the theoretical magnetic field 610. Beyond the theoretical threshold 611, any further increase of the theoretical magnetic field 610 is not correctly reflected in the magnetic field measurements of the magnetometer, such that an offset (or deviation) is produced. Particularly, the measured magnetic field 620 is degressively increasing compared to the increasing theoretical magnetic field 610 until a second theoretical threshold 612 is reached. At this second theoretical threshold 612 (and corresponding second measured threshold 622), the magnetometer is saturated. The second (theoretical and/or measured) threshold may also be referred to as a "saturation threshold". Thus, the saturation threshold describes a state of a magnetometer at which an external magnetic field influences the at least one magnetometer to such an extent that the at least one magnetometer is saturated. The operational range from zero to thresholds 612, 622 may be referred to as "full operation scale". A saturated magnetometer is a magnetometer the magnetic field measurements of which no longer increases if a magnetic field (e.g., of a magnetic object 22 of a user borne device 20) is moved closer to this magnetometer. As shown in the exemplary, magnetometer operation curve 600 of **Fig. 8****,** any further increase of the theoretical magnetic field 610 acting on the magnetometer, cannot be measured correctly by the magnetometer, but first leads to a stagnating measured magnetic field 620 before it decreases degressively.

One of the main ideas of the present disclosure is to reduce the magnetic influence of the disturbing magnetic source 520. As shown particularly, in **Figs. 1**, **2a**, **and 2b**, the electronic device 50 therefore comprises one or more balancing magnetic sources 400. In examples, the one or more balancing magnetic sources 400 may be arranged at, specifically fixed to, magnetometer body 320, the disturbing magnetic source 520, and/or the device body 530 of the electronic device 50. For instance, at least one of the one or more balancing magnetic sources 400 may be arranged at, specifically fixed to, the magnetometer body 320. Additionally or alternatively, at least one of the one or more balancing magnetic sources 400 may be arranged at, specifically fixed to, the disturbing magnetic source 520. Additionally or alternatively, at least one of the one or more balancing magnetic sources 400 may be arranged at, specifically fixed to, a device body 530 of the electronic device 50. The one or more balancing magnetic sources 400 are configured and arranged to reduce the magnetic effect on the at least one magnetometer S_{k,l}. In other words, the operational area of the magnetometer may be moved to the left with regards to **Fig. 8****.**

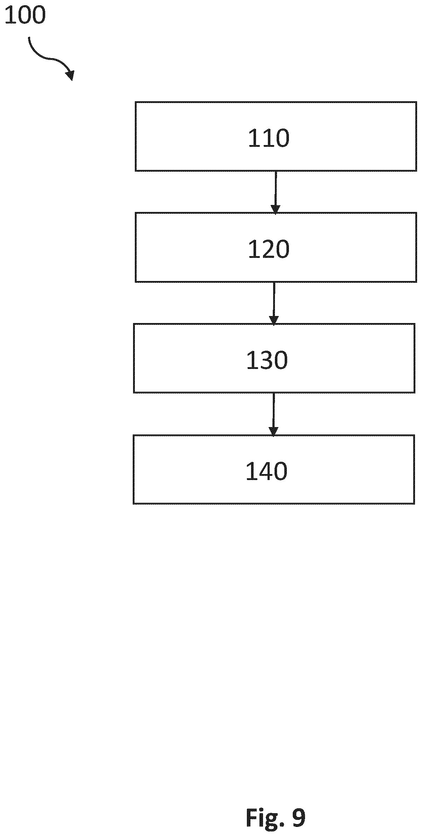

In more detail, the magnetometer sensing system 30 is magnetically calibrated according to the method 100 of the first aspect of the present disclosure. **Fig. 9** schematically illustrates a process flow diagram of the method 100 of magnetically calibrating a magnetometer sensing system 30 with respect to the electronic device 50. The steps need not necessarily be performed in the consecutive order as shown, but one or more steps may be performed parallelly or in a different order.

As shown in **Fig. 9****,** the method 100 comprises detecting 110 a disturbing magnetic source 520 in the electronic device 50 relative to the reference coordinate system X, Y, Z of the magnetometer sensing system 30. The method also comprises identifying 120 one or more magnetometers S_{k,l} of the magnetometer sensing system 30 which are magnetically affected by the detected disturbing magnetic source 520. Furthermore, the method comprises selecting 130 one or more balancing magnetic sources 400 to reduce a magnetic effect of the detected disturbing magnetic source 520 on the one or more identified magnetometers S_{k,l}. Additionally, the method comprises placing 140 the one or more selected balancing magnetic sources 400 in a fixed relation to the magnetometer sensing system 30 and/or to the disturbing magnetic source 520. It is noted that in respect to the schematic illustration of **Figs. 1****,** **2a, and 2b****,** the affected magnetometer is that magnetometer at position S_{k-1,l-1} , however, further magnetometers may be affected. For easy of reference, the present disclosure mainly refers to magnetometer "S_{k,l}" which, however, may stand for any other affected magnetometer (i.e. at another position in the rows and columns referred to in Fig. 3) of the plurality of magnetometers 300. By identifying 120 magnetometers S_{k,l} magnetically affected by the detected disturbing magnetic source 520 it can be precisely determined which areas of the plurality of magnetometers 300, more specifically, which exact magnetometers S_{k,l} of the plurality of magnetometers 300 require a magnetic calibration. Thereby, it is possible to carry out precise counter measures. The selection 130 and placement 140 of one or more balancing magnetic sources 400 provides an easy and effective solution to reduce the adverse effects of the disturbing magnetic source(s) 520. This may be achieved without a necessity to modify the disturbing magnetic source 520 itself (e.g. by re-locating, omitting the disturbing magnetic source 520 or replacing the disturbing magnetic source 520 by another less affecting element) which may in some circumstances be difficult (if not impossible) without sacrificing other functionalities of the electronic device 50 (e.g., magnetic locking, loudspeaker, etc.). Furthermore, the functionality of the affected magnetometer S_{k,l} may be improved compared to a not magnetically calibrated magnetometer S_{k,l}. Particularly, the accuracy of the magnetic field measurements may be improved, e.g. if the above mentioned non-linear area 634 and saturation area 636 are avoided. This in turn may lead to a more accurate result in movement and/or location determination of the user-borne device 20.

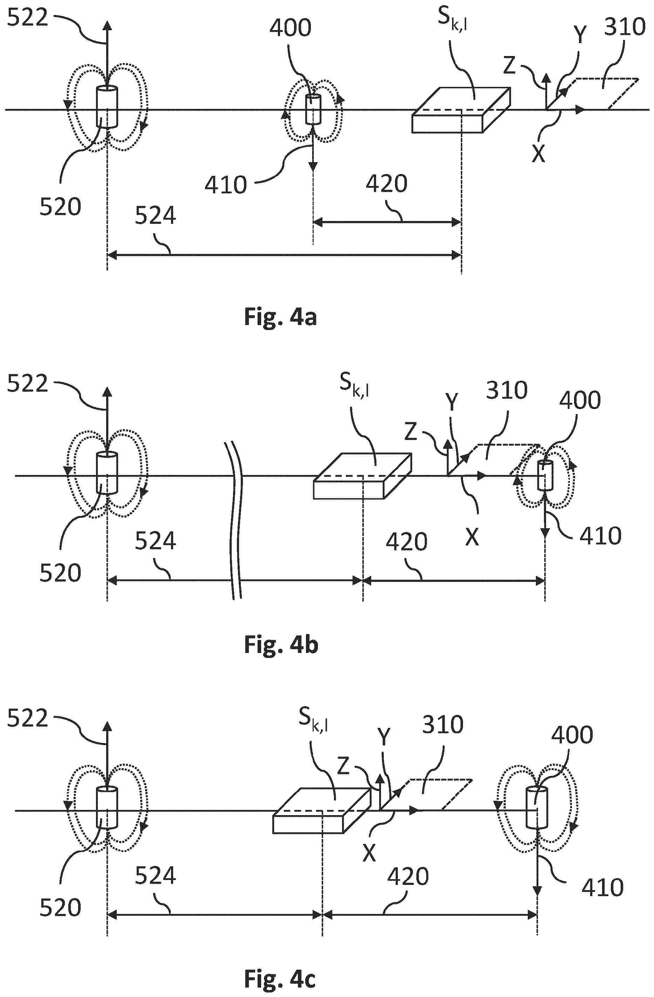

Further details of the method 100 and the disclosed arrangements will be explained with reference to **Figs. 4a to 4c****,** **5a** **and** **5b****,** **6****,** **7** **and** **10** in the following.

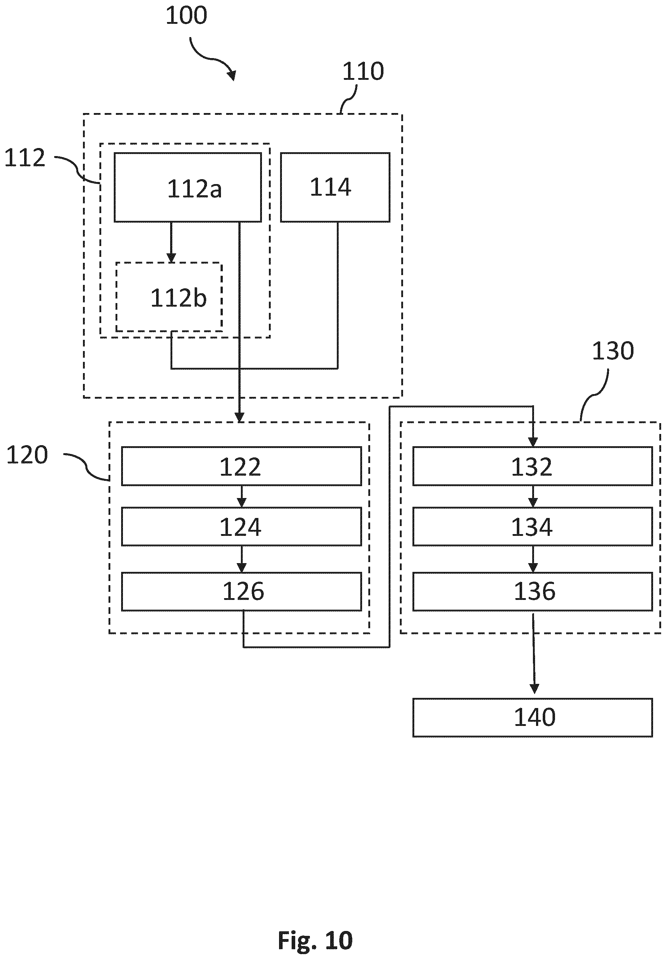

In that regard, **Fig. 10** schematically illustrates the method 100 in more detail. The step of detecting 110 the disturbing magnetic source 520 may comprise determining a magnetic field strength 114 of the disturbing magnetic source 520.

The step of detecting 110 the disturbing magnetic source 520 may comprise determining a location 112 of the disturbing magnetic source 520 relative to a location of the magnetometer sensing system 30. The location 112 of the disturbing magnetic source 520 may be understood as a position and/or an orientation of the disturbing magnetic source 520. Determining the location 112 of the disturbing magnetic source 520 may comprise obtaining 112a a position and/or an orientation of the disturbing magnetic source 520 relative to the reference coordinate system X, Y, Z. As mentioned above, the reference coordinate system X, Y, Z may be defined by the magnetometer sensing system 30. More specifically, the reference coordinate system X, Y, Z may be associated with a location of at least one magnetometer S_{k,l} of the magnetometer sensing system 30.

In some embodiments determining the location 112 of the disturbing magnetic source 520 may comprise obtaining 112b a position and/or an orientation of the magnetometer sensing system 30 relative to the reference coordinate system X, Y, Z. Specifically, a position and/or an orientation of at least one magnetometer S_{k,l} of the magnetometer sensing system 30 relative to the reference coordinate system X, Y, Z may be obtained 112b.

Detecting 110 the disturbing magnetic source 520 may be performed simulation based. Alternatively or additionally, detecting 110 the disturbing magnetic source 520 may be performed by obtaining magnetic field measurements associated with the disturbing magnetic source 520. In other words, a disturbing magnetic source 520 may be detected 110 by obtaining information on a disturbing magnetic source 520 via computer-simulation and/or via magnetic field measurements. Particularly, in measurement based approaches detecting 110 a disturbing magnetic source 520 may include detecting 110 a theoretical disturbing magnetic source 520 (or resulting disturbing magnetic source 520).

In some embodiments in which detecting 110 is based on obtaining magnetic field measurements, determining 114 the magnetic field strength of the disturbing magnetic source 520 may comprise determining the magnetic field induced by the disturbing magnetic source 520 on the one or more magnetometers S_{k,l} of the magnetometer sensing system 30. For instance, a magnetometer sensing system 30 (which may be the same which is to be used with the electronic device 50, or which may be a separate magnetometer sensing system 30, for instance, using magnetometers with a larger full operating scale than the one to be used with the electronic device, such as a gauss meter or a zero gauss chamber) may obtain magnetic field measurements from the electronic device 50. Based on the obtained magnetic field measurements, magnetic field measurement data may be generated which is indicative of a magnetic moment vector 522 of the disturbing magnetic source(s) 520 (i.e., a magnetic field orientation and/or a magnetic field strength) relative to a measurement coordinate system of the magnetometer sensing system 30 which was used for obtaining the measurements (e.g. the reference coordinate system X, Y, Z). For instance, the magnetic field of the disturbing magnetic source(s) 520 can be interpolated based on magnetic field measurement data. In knowledge of the location of the magnetometer sensing system 50 (used for the magnetic field measurements) relative to the electronic device 50, the orientation and strength of a disturbing magnetic source can be determined. Furthermore, a position of the disturbing magnetic source 520 (e.g., an origin of the magnetic field of the disturbing magnetic source 520) may be determined based on the interpolation of the magnetic field measurement data.

In a simulation based detection step 110, information on the disturbing magnetic source(s) 520 may be obtained, e.g. from a database. For instance, a three-dimensional model of the electronic device 50 including its components may be obtained. Furthermore, information on magnetic properties of the components of the electronic device 50 may be obtained. Additionally, a mounting location of the magnetometer sensing system 30 relative to the components of the electronic device 50 may be obtained. Based on simulation approaches it can be estimated if and to what extent a component of the electronic device 50 magnetically affects the magnetometer sensing system 30 as will be explained in further detail with respect to the identification step 120 below. Particularly, a superposition of the disturbing magnetic source 520 on the magnetometer sensing system 30 may be evaluated. In more detail, the magnetic moment vector 522 (i.e., the magnetic field strength and the magnetic field orientation) of the disturbing magnetic source 520 may be evaluated. Subsequently, selecting 130 and placing 140 one or more balancing magnetic sources 40 may be performed based on the evaluated magnetic moment vector 522.

With further reference to **Fig. 10****,** identifying 120 one or more magnetometers S_{k,l} may comprise determining 122 a magnetic effect of a magnetic field created by the disturbing magnetic source 520 on one or more magnetometers S_{k,l} of the magnetometer sensing system 30. Furthermore, identifying 120 one or more magnetometers S_{k,l} may comprise evaluating 124 if the magnetic effect exceeds a disturbing threshold of the magnetometer sensing system 30. Specifically, it may be evaluated 124 if the magnetic effect exceeds a disturbing threshold of the one or more magnetically affected magnetometers S_{k,l}. Specifically, a magnetometer S_{k,l} of the magnetometer sensing system 30 may be identified 120 if the determined magnetic effect on this magnetometer S_{k,l} exceeds the disturbing threshold.

The disturbing threshold may be based on a saturation threshold 612, 622 of one or more magnetometers S_{k,l} of the magnetometer sensing system 30 (see, also explanations above with respect to **Fig. 8****).** In some embodiments, the disturbing threshold may be based on a non-linear area threshold 611, 621 of one or more magnetometers S_{k,l} of the magnetometer sensing system 30 (see, also explanations above with respect to **Fig. 8****).** For instance, the disturbing threshold may be set at the saturation threshold 612, 622 or below. In other examples, the disturbing threshold may be set at the non-linear area threshold 611, 621 or below. Specifically, the disturbing threshold may be set at a value between 10% to 100%, specifically between 20% to 80% and more specifically between 30% to 50% of the non-linear area threshold 611, 621 or of the saturation threshold 612, 622. For instance, if the non-linear area threshold 611, 621 may be about 2.500 µT, the disturbing threshold may be set at 50%, i.e., at about 1.225 µT. In other examples, the disturbing threshold may be set at a value from about 1000µT to about 4000µT, specifically from about 1500µT to about 3500µT, and more specifically from about 2000µT to about 3000µT, for example at about 2500µT. The disturbing threshold of a magnetometer S_{k,l} may refer to a threshold at a geometrical center of a respective magnetometer S_{k,l}, e.g. the intersection point of the three axes of a three-axis magnetometer S_{k,l}. In some embodiments, the disturbing threshold of a magnetometer may be evaluated for one or more axes of the three-axis magnetometer.

In some embodiments, it may be evaluated 124 if the magnetic effect exceeds a disturbing threshold of the magnetometer sensing system 30 during regular use of the magnetometer sensing system 30. That means a magnetic effect of the user borne device 20, the magnetometer sensing system 30 is to be used with may be considered. For instance, if during regular use, the user borne device acts with a magnetic field strength of about 1.500µT on the magnetometer S_{k,l}, the disturbing threshold may be set at a value at least 1.500µT below the non-linear area threshold 611, 621 or the saturation threshold 612, 622. Thereby, a risk that the magnetometer operation curve 600 of the magnetometer S_{k,l} may be moved into the non-linear area 634 or the saturation area 636, respectively, may be prevented or at least reduced. Described more generally, a magnetic field strength of a user borne device 20 the magnetometer sensing system 30 is to be used with may be considered for setting the disturbing threshold. For instance, the disturbing threshold may be set to one of the saturation threshold 612, 622 or the non-linear area threshold 611, 621, reduced by the magnetic field strength of the user borne device 20. Thereby, even during use, saturation 636, respectively, a non-linear operation area 634 may be avoided.

With further reference to **Figs. 4a-4c****,** **5a-5b****,** **6****,** **7** **and** **10****,** selecting 130 one or more balancing magnetic sources 400 may comprise selecting a magnetic field strength 134 of balancing magnetic sources 400 and/or selecting a location 136 of balancing magnetic sources 400. In embodiments, selecting a location 136 may include selecting a position of the balancing magnetic source 40 and an orientation of the balancing magnetic source 40. In some embodiments, selecting 130 one or more balancing magnetic sources 400 may comprise selecting a number 132 of balancing magnetic sources 400.

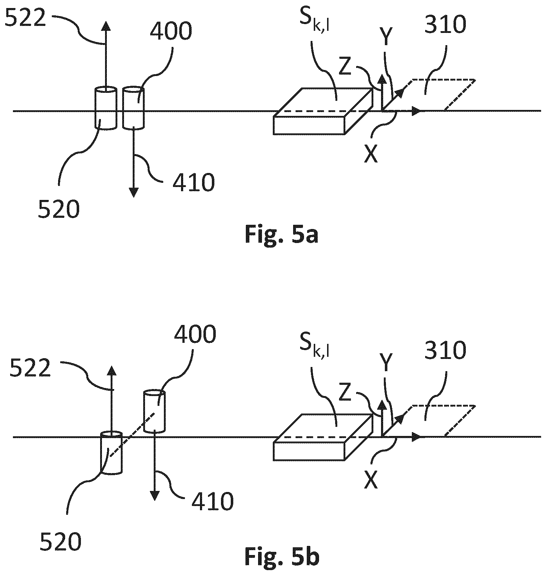

According to one example configuration and as shown particularly in **Figs. 4a-4c****,** **5a-5b****,** one balancing magnetic source 400 may be selected 132 for reducing the magnetic effect of the detected disturbing magnetic source 520. Particularly but not necessarily, if the disturbing magnetic source 520 has a magnetic effect on only one magnetometer S_{k,l} of the magnetometer sensing system 30, only one balancing magnetic source 400 may be selected 132. The magnetic field strength of the one balancing magnetic source 400 may selected 134 to be equal or less than a magnetic field strength of the disturbing magnetic source 520. In **Figs. 4a-4c****,** **5a-5b** (and also in Figs. 2b, 6 and 7), relative magnetic field strengths are schematically illustrated by different sizes of the balancing magnetic sources 400 and of the disturbing magnetic sources 520, respectively. For instance, in the examples of **Figs. 4c****,** **5a, 5b****,** the balancing magnetic source 400 and the disturbing magnetic source 520 have about the same size which shall illustrate that their magnetic field strengths are about equal. In comparison thereto, in the examples of **Figs. 4a, 4b****,** the balancing magnetic source 400 is smaller than the disturbing magnetic source 520, and thus has a smaller magnetic field strength than that of the disturbing magnetic source 520.

Selecting a location 136 of the one balancing magnetic source 400 may include selecting a position of the one balancing magnetic source 400 within a range about a distance 420 from the one magnetometer S_{k,l}. Specifically, the magnetic field strength of the one balancing magnetic source 400 and the distance 420 from the one magnetometer S_{k,l} to the one balancing magnetic source 400 may be selected based on at least one of a distance 524 from the one magnetometer S_{k,l} to the disturbing magnetic source 520 and the magnetic field strength of the disturbing magnetic source 520. In an example, the magnetic field strength and the position of the one balancing magnetic source 400 is selected such that a ratio of its magnetic field strength to the distance 420 in the third exponent equals a corresponding ratio of the disturbing magnetic source 520. In detail, the corresponding ratio of the disturbing magnetic source 520 is a ratio of the magnetic field strength of the disturbing magnetic source 520 divided by the distance 524 from the one magnetometer S_{k,l} to the disturbing magnetic source 520 in the third exponent (i.e., ratio=[magnetic field strength/(distance)³]).

As mentioned before, selecting a location 136 of the one balancing magnetic source 400 may also include selecting an orientation of the one balancing magnetic source 400. The orientation of the one balancing magnetic source 400 may be selected substantially opposite to an orientation of the disturbing magnetic source 520. In that regard, the respective orientations may be represented by the respective magnetic moment vectors 410, 522 of the balancing magnetic source 400 and the disturbing magnetic source 520, respectively. As shown in the **Figs. 4a-4c****,** **5a-5b** (and also in Figs. 2b, 6 and 7), the magnetic moment vector 410 of the balancing magnetic source 400 is exemplary pointing downwardly, and the magnetic moment vector 522 of the disturbing magnetic source 520 is exemplary pointing upwardly, and thus, substantially in an opposite direction. In more detail, the orientation of the magnetic field created by the one balancing magnetic source is selected to be substantially opposite to the orientation of the magnetic field created by the disturbing magnetic source. The term "substantially" may include deviations of up to about 5° from the orientation of the magnetic field of the disturbing magnetic source 520.

As shown in the examples of **Figsb**. **4a, 5a, 5b,** the position of the one balancing magnetic source 400 may be selected to be on a same side as the disturbing magnetic source 520 with respect to the one magnetometer S_{k,l}. Specifically, the one balancing magnetic source 400 may be arranged on a straight line which goes through the disturbing magnetic source 520 and the one magnetometer S_{k,l} (specifically, the line may go through the respective centers of the disturbing magnetic source 520 and the one magnetometer S_{k,l}).

In the example according to **Fig. 4a****,** the position of the one balancing magnetic source 400 is selected to be between the disturbing magnetic source 520 and the one magnetometer S_{k,l}. If the balancing magnetic source 400 is positioned between the disturbing magnetic source 520 and the one magnetometer, the magnetic strength of the balancing magnetic source 400 may be selected to be lower than that of the disturbing magnet source 520. For instance, the magnetic strength of the balancing magnetic source 400 and its exact position (i.e., its distance 420 to the one magnetometer S_{k,l}) may be selected according to the equation of ratios mentioned above.

Alternatively and as shown in the examples of **Figs. 5a, 5b****,** the one balancing magnetic source 400 may be positioned at or in close proximity (e.g., <10mm) next to the disturbing magnetic source 520. In such embodiments, the magnetic field strength of the one balancing magnetic source 400 may be equal to the magnetic field strength of the disturbing magnetic source 520. As mentioned before the orientation of the magnetic moment vector 410 of the one balancing magnetic source 400 is oriented in a direction opposite to the magnetic moment vector 522 of the disturbing magnetic source 520. In the configuration of **Fig. 5a****,** the one balancing magnetic source 400 is exemplary located next to the disturbing magnetic source 520 in an X-direction of the reference coordinate system X, Y, Z. In the configuration of **Fig. 5b****,** the one balancing magnetic source 400 is exemplary located next to the disturbing magnetic source 520 in a Y-direction of the reference coordinate system X, Y, Z. It should be understood that the one balancing magnetic source 400 may also be located next to the disturbing magnetic source 520 in any other direction (e.g., Z-direction), or any combination of one or more directions of the reference coordinate system X, Y, Z. In which direction the one balancing magnetic source 400 is located next to the disturbing magnetic source 520, may be decided based on space constraints or other requirements (e.g., less influence of other components or magnetometers S_{k,l}.) in the electronic device 50 or magnetometer body 320.

As shown in the examples of **Figs. 4b, 4c**, the position of the one balancing magnetic source 400 may be selected to be on a opposite side as the disturbing magnetic source 520 with respect to the one magnetometer S_{k,l}. Specifically, the one balancing magnetic source 400 may be arranged on a straight line which goes through the disturbing magnetic source 520 and the one magnetometer S_{k,l} (specifically, the line may go through the respective centers of the disturbing magnetic source 520 and the one magnetometer S_{k,l}).

In the example according to **Fig. 4b****,** the position of the one balancing magnetic source 400 is selected to be at a closer distance 420 to the one magnetometer S_{k,l} than the distance 524 between the disturbing magnetic source 520 and the one magnetometer S_{k,l}. Furthermore, the magnetic strength of the balancing magnetic source 400 may be selected to be lower than that of the disturbing magnet source 520. For instance, the magnetic strength of the balancing magnetic source 400 and its exact position (i.e., its distance 420 to the one magnetometer S_{k,l}) may be selected according to the equation of ratios mentioned above.

In the example according to **Fig. 4c****,** the position of the one balancing magnetic source 400 is selected such that its distance 420 to the one magnetometer S_{k,l} is about the same as the distance 524 between the disturbing magnetic source 520 and the one magnetometer S_{k,l}. Furthermore, the magnetic strength of the balancing magnetic source 400 may be selected to be equal (but oriented opposite) to that of the disturbing magnet source 520.

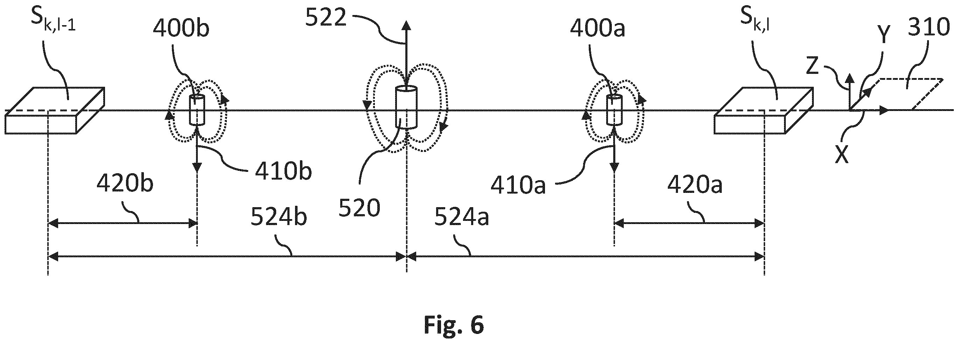

According to another example configuration and as shown particularly in **Fig. 6****,** one balancing magnetic source 400 may be selected 132 for each magnetometer S_{k,l} magnetically affected by the detected disturbing magnetic source 520 for reducing the magnetic effect of the detected disturbing magnetic source 520. **Fig. 6** exemplary shows (very schematically) a disturbing magnetic source 520 which is arranged between a first affected magnetometer S_{k,l} and a second affected magnetometer S_{k,l-1}. A first balancing magnetic source 400a may be selected to reduce the magnetic effect of the detected disturbing magnetic source 520 on the first affected magnetometer S_{k,l}. A second balancing magnetic source 400b may be selected to reduce the magnetic effect of the detected disturbing magnetic source 520 on the second affected magnetometer S_{k,l-1}.

The magnetic field strength of each balancing magnetic source 400a, 400b may be selected 134 to be less than a magnetic field strength of the disturbing magnetic source 520. The magnetic field strength of each balancing magnetic source 400a, 400b may be selected 134 such that their resulting balancing magnetic field strength acting on the disturbing magnetic source 520 is equal to the magnetic field strength of the disturbing magnetic source 520.

Selecting a location 136 of each balancing magnetic source 400a, 400b may include selecting a respective position of each balancing magnetic source 400a, 400b within a range about a distance 420a, 420b from the respective magnetometer S_{k,l}, S_{k,l-1}. The position of the respective balancing magnetic source 400a, 400b may be selected to be on a same side as the disturbing magnetic source 520 with respect to the one magnetometer S_{k,l}. The magnetic field strength of the respective balancing magnetic source 400a, 400b and the distance 420a, 420b from each magnetometer S_{k,l}, S_{k,l-1} to the respective balancing magnetic source 400a, 400b may be selected based on at least one of a distance 524a, 524b from the respective magnetometer S_{k,l}, S_{k,l-1} to the disturbing magnetic source 520 and the magnetic field strength of the disturbing magnetic source 520.

Considering exemplary the first affected magnetometer S_{k,l}, the position of the first balancing magnetic source 400a may be selected to be on a same side as the disturbing magnetic source 520 with respect to the first magnetometer S_{k,l}, and particularly between the disturbing magnetic source 520 and the first magnetometer S_{k,l}. Specifically, the first balancing magnetic source 400a may be arranged on a straight line which goes through the disturbing magnetic source 520 and the first magnetometer S_{k,l}. The magnetic field strength of the first balancing magnetic source 400a, and the distance 420a from the first magnetometer S_{k,l} to the first balancing magnetic source 400a may be selected based on at least one of a distance 524a from the first magnetometer S_{k,l} to the disturbing magnetic source 520 and the magnetic field strength of the disturbing magnetic source 520. In an example, the magnetic field strength and the position of the first balancing magnetic source 400a is selected such that a ratio of its magnetic field strength to the distance 420a in the third exponent equals a corresponding ratio of the disturbing magnetic source 520. In detail, the corresponding ratio of the disturbing magnetic source 520 is a ratio of the magnetic field strength of the disturbing magnetic source 520 divided by the distance 524a from the first magnetometer S_{k,l} to the disturbing magnetic source 520 in the third exponent (i.e., ratio=[magnetic field strength/(distance)³]). These explanations apply analogously to the second magnetometer S_{k,l-1} and to the second balancing magnetic source 400b.

As mentioned before, selecting a location 136 of each balancing magnetic source 400a, 400b may also include selecting an orientation of the each balancing magnetic source 400a, 400b. The orientation of each balancing magnetic source 400a, 400b may be selected substantially opposite to an orientation of the disturbing magnetic source 520. Specifically, the orientations of each balancing magnetic source 400a, 400b may be selected to generate a resulting balancing magnetic field which is substantially opposite to an orientation of the disturbing magnetic source 520. As mentioned above, the magnetic field strength of each balancing magnetic source 400a, 400b may be selected 134 such that their resulting balancing magnetic field strength acting on the disturbing magnetic source 520 is equal to the magnetic field strength of the disturbing magnetic source 520. In that regard, the respective orientations may be represented by the respective magnetic moment vectors 410a, 410b, 522 of the balancing magnetic sources 400a, 400b and the disturbing magnetic source 520, respectively.

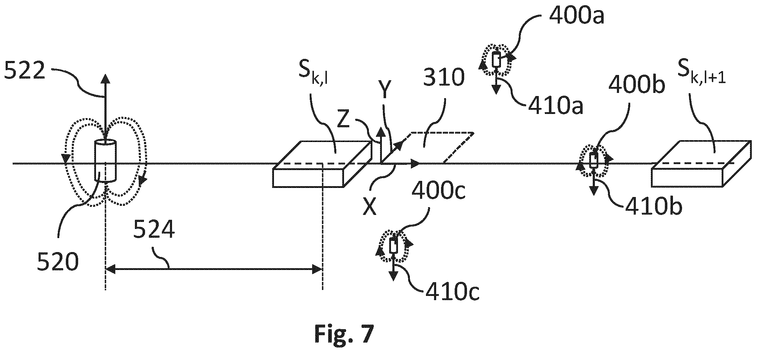

The example configuration shown in **Fig. 6****,** represent a further modification based on the configurations of **Figs. 4b and 4c****,** whereby the one selected balancing magnetic source 400 is replaced by several balancing magnetic sources 400a, 400b, 400c of smaller magnetic strength. In other words, several balancing magnetic sources 400a, 400b, 400c may be selected 132 for each magnetometer S_{k,l} magnetically affected by the detected disturbing magnetic source 520. Using several balancing magnetic sources 400a, 400b, 400c of smaller magnetic strength helps to reduce the potential magnetic effect of balancing magnetic sources 400a, 400b, 400c on other magnetometers and/or components of electronic device 50 (e.g. hard drive). As shown in the exemplary configuration of **Fig. 7****,** three balancing magnetic sources 400a, 400b, 400c of similar magnetic strength may be selected. However, in other variations of this configuration, more or less (at least two) than three balancing magnetic sources 400a, 400b, 400c may be selected. Also the magnetic strengths and/or orientations of the respective magnetic fields of the balancing magnetic sources 400a, 400b, 400c may be different to reduce the magnetic effect of balancing magnetic sources 400a, 400b, 400c on other components or magnetometers. In some embodiments, the magnetic strengths and/or orientations of the balancing magnetic sources 400a, 400b, 400c may be selected such that one respective balancing magnetic source 400a, 400b, 400c reduces one component (e.g. X, Y, and Z-component) of the resulting disturbing magnetic field 522 of the disturbing magnetic source 520.

In the embodiments shown in the figures, the one or more selected balancing magnetic source 400 are permanent magnets. Generally, the balancing magnetic source 400 may comprise at least one of permanent magnet, an electromagnet, and/or a coil. In general, a "balancing magnetic source" may be as a source of a magnetic field which is dedicated for balancing another magnetic field.

In some embodiments, at least one of the one or more selected balancing magnetic source 400 may be mounted at or in the magnetometer sensing system 30 prior to assembling the magnetometer sensing system 30 in the electronic device 50. In an example embodiment, a spherical balancing magnetic source may be placed in a receiving element which enables to rotate the spherical balancing magnetic source in three dimensions. After rotating/orienting the spherical balancing magnetic source it may be fixed in the receiving element. In examples, fixing the spherical balancing magnetic source may comprise using a locking mechanism. In embodiments, a calibration optimisation step may be performed which may comprise selecting a sphere volume, selecting a remanent field and orienting the spherical balancing magnetic source to minimize an offset on the plurality of magnetometers. In embodiments, selecting a sphere volume may comprise selecting a sphere dimension (e.g. a diameter of the spherical balancing magnetic source). Selecting a sphere volume and a remanent field may be done to achieve a desired magnetic field strength as described in the above method steps. One or more receiving elements may be provided in the magnetometer sensing system 30 and/or in the electronic device 50. Particularly, one or more receiving elements may be provided at predetermined locations with respect to the magnetometers of the magnetometer sensing system 30.

In embodiments, at least one of the one or more selected balancing magnetic source 400 may be mounted at or in a device body 530 of the electronic device 50.

Although the present invention has been described above and is defined in the attached claims, it should be understood that the invention may alternatively be defined in accordance with the following embodiments:
1. A method (100) of magnetically calibrating a magnetometer sensing system (30) with respect to an electronic device (50), the method (100) comprising:
   detecting (110) a disturbing magnetic source (520) in the electronic device (50) relative to a reference coordinate system (X, Y, Z) of the magnetometer sensing system (30);
   identifying (120) one or more magnetometers (S_{k,l}) of the magnetometer sensing system (30) which are magnetically affected by the detected disturbing magnetic source (520);
   selecting (130) one or more balancing magnetic sources (400) to reduce a magnetic effect of the detected disturbing magnetic source (520) on the one or more identified magnetometers (S_{k,l}); and
   placing (140) the one or more selected balancing magnetic sources (400) in a fixed relation to the magnetometer sensing system (30) and/or to the disturbing magnetic source (520).
2. The method (100) of embodiment 1, wherein detecting (110) the disturbing magnetic source (520) comprises determining a magnetic field strength (114) of the disturbing magnetic source (520) and/or determining a location (112) of the disturbing magnetic source (520) relative to a location of the magnetometer sensing system (30).
3. The method (100) of embodiment 2, wherein determining the location (112) of the disturbing magnetic source (520) comprises obtaining (112a) a position and/or an orientation of the disturbing magnetic source (520) relative to the reference coordinate system (X, Y, Z).
4. The method (100) of any one of the preceding embodiments, wherein the reference coordinate system (X, Y, Z) is defined by the magnetometer sensing system (30), more specifically wherein the reference coordinate system (X, Y, Z) is associated with a location of at least one magnetometer (S_{k,l}) of the magnetometer sensing system (30).
5. The method (100) of any one embodiments 2 or 3, wherein determining the location (112) of the disturbing magnetic source (520) comprises obtaining (112b) a position and/or orientation of the magnetometer sensing system (30) relative to the reference coordinate system (X, Y, Z), specifically obtaining (112b) a position and/or orientation of at least one magnetometer (S_{k,l}) of the magnetometer sensing system (30) relative to the reference coordinate system (X, Y, Z).
6. The method (100) of any one of the preceding embodiments, wherein detecting (110) the disturbing magnetic source (520) is performed simulation based and/or wherein detecting (110) the disturbing magnetic source (520) is performed by obtaining magnetic field measurements associated with the disturbing magnetic source (520).
7. The method (100) of any one of the preceding embodiments, wherein identifying (120) one or more magnetometers (S_{k,l}) comprises determining (122) a magnetic effect of a magnetic field created by the disturbing magnetic source (520) on one or more magnetometers (S_{k,l}) of the magnetometer sensing system (30).
8. The method (100) of embodiment 7, wherein identifying (120) one or more magnetometers (S_{k,l}) comprises evaluating (124) if the magnetic effect exceeds a disturbing threshold of the magnetometer sensing system (30), specifically of the one or more magnetically affected magnetometers (S_{k,l}), particularly during use.
9. The method (100) of embodiment 8, wherein a magnetometer (S_{k,l}) of the magnetometer sensing system (30) is identified (120) if the determined magnetic effect on this magnetometer (S_{k,l}) exceeds the disturbing threshold.
10. The method (100) of any one of embodiments 8 or 9, wherein the disturbing threshold is based on a saturation threshold of one or more magnetometers (S_{k,l}) of the magnetometer sensing system (30), specifically, wherein the disturbing threshold is set at the saturation threshold or below.
11. The method (100) of any one of the preceding embodiments, wherein selecting (130) one or more balancing magnetic sources (400) comprises selecting a number (132) of balancing magnetic sources (400), selecting a magnetic field strength (134) of balancing magnetic sources (400) and/or selecting a location (136) of balancing magnetic sources (400).
12. The method (100) of embodiment 11, wherein one balancing magnetic source (400) is selected for reducing the magnetic effect of the detected disturbing magnetic source (520).
13. The method (100) of embodiment 12, and optionally if the disturbing magnetic source (520) has a magnetic effect on only one magnetometer (S_{k,l}) of the magnetometer sensing system (30), wherein the magnetic field strength of the one balancing magnetic source (400) is selected to be equal or less than a magnetic field strength of the disturbing magnetic source (520).
14. The method (100) of embodiment 13, wherein selecting a location (136) of the one balancing magnetic source (400) includes selecting a position of the one balancing magnetic source (400) within a range about a distance (420) from the one magnetometer (S_{k,l}), and wherein selecting a location (136) of the one balancing magnetic source (400) includes selecting an orientation of the one balancing magnetic source (400).
15. The method (100) of embodiment 14, wherein the magnetic field strength of the one balancing magnetic source (400) and the distance (420) from the one magnetometer (S_{k,l}) to the one balancing magnetic source (400) is selected based on at least one of a distance (524) from the one magnetometer (S_{k,l}) to the disturbing magnetic source (520) and the magnetic field strength of the disturbing magnetic source (520).
16. The method (100) of any one of embodiments 14 or 15, wherein the magnetic field strength and the position of the one balancing magnetic source (400) is selected such that a ratio of its magnetic field strength to the distance (420) in the third exponent equals a corresponding ratio of the disturbing magnetic source (520).
17. The method (100) of any one of embodiments 14 to 16, wherein the position of the one balancing magnetic source (400) is selected to be on a same side as the disturbing magnetic source (520) with respect to the one magnetometer (S_{k,l}).
18. The method (100) of embodiment 17, wherein the position of the one balancing magnetic source (400) is selected to be between the disturbing magnetic source (520) and the one magnetometer (S_{k,l}).
19. The method (100) of any one of embodiments 13 to 16, wherein the position of the one balancing magnetic source (400) is selected to be on a opposite side as the disturbing magnetic source (520) with respect to the one magnetometer (S_{k,l}).
20. The method (100) of any one of embodiments 12 to 19, wherein the orientation of the one balancing magnetic source (400) is selected substantially opposite to an orientation of the disturbing magnetic source (520).
21. The method (100) of embodiment 11, wherein one balancing magnetic source (400) is selected for each magnetometer (S_{k,l}) magnetically affected by the detected disturbing magnetic source (520).
22. The method (100) of embodiment 21, wherein the magnetic field strength of each balancing magnetic source (400) is selected to be less than a magnetic field strength of the disturbing magnetic source (520).
23. The method (100) of embodiment 21, wherein selecting a location (136) of each balancing magnetic source (400) includes selecting a position of a respective balancing magnetic source (400) within a range about a distance (420) from one magnetically affected magnetometer (S_{k,l}), and wherein selecting a location (136) of each balancing magnetic source (400) includes selecting an orientation of the respective balancing magnetic source (400).
24. The method (100) of embodiment 23, wherein the magnetic field strength of the respective balancing magnetic source (400) and the distance (420) from each magnetometer (S_{k,l}) to the respective balancing magnetic source (400) is selected based on at least one of a distance (524) from the respective magnetometer (S_{k,l}) to the disturbing magnetic source (520) and the magnetic field strength of the disturbing magnetic source (520).
25. The method (100) of any one of embodiments 23 or 24, wherein the magnetic field strength and the position of the respective balancing magnetic source (400) is selected such that a ratio of its magnetic field strength to the distance (420) in the third exponent equals a corresponding ratio of the disturbing magnetic source (520).
26. The method (100) of any one of embodiments 23 to 25, wherein the position of the respective balancing magnetic source (400) is selected to be on a same side as the disturbing magnetic source (520) with respect to the one magnetometer (S_{k,l}).
27. The method (100) of embodiment 11, wherein several balancing magnetic sources (400) are selected for each magnetometer (S_{k,l}) magnetically affected by the detected disturbing magnetic source (520).
28. The method (100) of any one of the preceding embodiments, wherein the one or more selected balancing magnetic source (400) are permanent magnets.
29. The method (100) of any one of the preceding embodiments, wherein at least one of the one or more selected balancing magnetic source (400) is mounted at or in the magnetometer sensing system (30) prior to assembling the magnetometer sensing system in the electronic device.
30. The method (100) of any one of the preceding embodiments, wherein at least one of the one or more selected balancing magnetic source (400) is mounted at or in a device body (530) of the electronic device (50).
31. An electronic device (50) for determining a location of at least one user-borne device (20) comprising at least one magnetic object (22), the electronic device (50) comprising:
   a magnetometer sensing system (30) including at least one plurality of magnetometers (300),
   at least one disturbing magnetic source (520) configured to generate a magnetic field having a magnetic effect on at least one magnetometer (S_{k,l}) of the magnetometer sensing system (30), and
   one or more balancing magnetic sources (400) being configured and arranged to reduce the magnetic effect on the at least one magnetometer (S_{k,l}),
   wherein the magnetometer sensing system (30) is magnetically calibrated according to the method of any one of the preceding embodiments.
32. The electronic device (50) of embodiment 31, wherein the magnetometer sensing system (30) is arranged at or in a device body (530) of the electronic device (50).
33. The electronic device (50) of any one of embodiments 31 or 32, wherein the magnetometer sensing system (30) is configured to obtain magnetic field measurements which are indicative of a magnetic field associated with the at least one magnetic object (22).
34. The electronic device (50) of any one of embodiments 31 to 33, wherein the electronic device (50) comprises or is a notebook, a laptop, a smartphone, a screen, a board or a tablet.
35. The electronic device (50) of any one of embodiments 31 to 34, wherein the electronic device (50) comprises or is connectable to a processing unit (40) configured determine a user-borne device location, specifically configured to determine an absolute magnetic object location indicative of an absolute magnetic object position and/or an absolute magnetic object orientation of the at least one magnetic object (22) relative to the reference coordinate system (X, Y, Z), more specifically wherein the absolute magnetic object location is determined based on obtained magnetic field measurements.
36. The electronic device (50) of embodiment 35, wherein the processing unit (40) is configured to generate magnetic field measurement data based on obtained magnetic field measurements, wherein the magnetic field measurement data is indicative of a magnetic moment vector of the at least one magnetic object (22) relative to the reference coordinate system (X, Y, Z).
37. The electronic device (50) of embodiment 36, wherein the processing unit (40) is configured to determine the absolute magnetic object location by processing magnetic field measurement data to relate magnetic field measurement data to an absolute magnetic object location.
38. The electronic device (50) of any one of embodiments 31 to 37, comprising a device body (530), the device body (530) comprises a first device part (531) and a second device part (532), and optionally, wherein the magnetometer sensing system (30) is arranged in the first device part (531).
39. The electronic device (50) of any one of embodiments 31 to 38, wherein the magnetometer sensing system (50) comprises a first plurality of magnetometers (300a) and a second plurality of magnetometers (300b).
40. The electronic device (50) of any one of embodiments 31 to 39, comprising at least one output device (510), more specifically wherein the at least one output device (510) comprises a display or a screen.
41. The electronic device (50) of any one of embodiments 31 to 40, wherein the at least one disturbing magnetic source (520) comprises at least one of a speaker, a fan and/or a magnetic lock.
42. The electronic device (50) of any one of embodiments 31 to 41, wherein the plurality of magnetometers (300) are arranged in a magnetometer body (320), and wherein at least one of the one or more balancing magnetic sources (400) is arranged at, specifically fixed to, the magnetometer body (320).
43. The electronic device (50) of any one of embodiments 31 to 42, wherein at least one of the one or more balancing magnetic sources (400) is arranged at, specifically fixed to, the disturbing magnetic source (520).
44. The electronic device (50) of any one of embodiments 31 to 43, wherein at least one of the one or more balancing magnetic sources (400) is arranged at, specifically fixed to, a device body (530) of the electronic device (50).
45. The electronic device (50) of any one of embodiments 31 to 44, wherein the plurality of magnetometers (300) define a magnetometer plane (310), and wherein the disturbing magnetic source (520) is arranged substantially in the magnetometer plane (310).
46. A system (10) for determining a location of at least one user-borne device (20), comprising:
   at least one user-borne device (20) comprising at least one magnetic object (22), wherein
   the user borne device (20) is operable with respect to an interaction surface (210) of the system (10),
   an electronic device (50) of any one of embodiments 31 to 45, wherein the magnetometer sensing system (30) is configured to obtain magnetic field measurements associated with the at least one magnetic object (22).
47. The system (10) of embodiment 46, wherein the system (10) is configured to track a movement of the at least one magnetic object (22) in at least five degrees of freedom.
48. The system (10) of any one of embodiments 46 or 47, wherein, during a user operation, the system (10) is configured to track a movement of the at least one user borne device (20) relative to the interaction surface (210) over a time period.
49. The system (10) of any one of embodiments 46 to 48, wherein the at least one user-borne device (20) is electrically and/or electronically passive.

## Claims

1. A method (100) of magnetically calibrating a magnetometer sensing system (30) with respect to an electronic device (50), the method (100) comprising:
detecting (110) a disturbing magnetic source (520) in the electronic device (50) relative to a reference coordinate system (X, Y, Z) of the magnetometer sensing system (30);
identifying (120) one or more magnetometers (S_{k,l}) of the magnetometer sensing system (30) which are magnetically affected by the detected disturbing magnetic source (520);
selecting (130) one or more balancing magnetic sources (400) to reduce a magnetic effect of the detected disturbing magnetic source (520) on the one or more identified magnetometers (S_{k,l}); and
placing (140) the one or more selected balancing magnetic sources (400) in a fixed relation to the magnetometer sensing system (30) and/or to the disturbing magnetic source (520).

2. The method (100) of claim 1, wherein detecting (110) the disturbing magnetic source (520) comprises determining a magnetic field strength (114) of the disturbing magnetic source (520) and/or determining a location (112) of the disturbing magnetic source (520) relative to a location of the magnetometer sensing system (30).

3. The method (100) of any one of the preceding claims, wherein identifying (120) one or more magnetometers (S_{k,l}) comprises determining (122) a magnetic effect of a magnetic field created by the disturbing magnetic source (520) on one or more magnetometers (S_{k,l}) of the magnetometer sensing system (30).

4. The method (100) of claim 3, wherein identifying (120) one or more magnetometers (S_{k,l}) comprises evaluating (124) if the magnetic effect exceeds a disturbing threshold of the magnetometer sensing system (30), specifically of the one or more magnetically affected magnetometers (S_{k,l}), particularly during use.

5. The method (100) of any one of the preceding claims, wherein selecting (130) one or more balancing magnetic sources (400) comprises selecting a number (132) of balancing magnetic sources (400), selecting a magnetic field strength (134) of balancing magnetic sources (400) and/or selecting a location (136) of balancing magnetic sources (400).

6. The method (100) of claim 5, and optionally if the disturbing magnetic source (520) has a magnetic effect on only one magnetometer (S_{k,l}) of the magnetometer sensing system (30), wherein one balancing magnetic source (400) is selected for reducing the magnetic effect of the detected disturbing magnetic source (520), and wherein the magnetic field strength of the one balancing magnetic source (400) is selected to be equal or less than a magnetic field strength of the disturbing magnetic source (520).

7. The method (100) of claim 6, wherein selecting a location (136) of the one balancing magnetic source (400) includes selecting a position of the one balancing magnetic source (400) within a range about a distance (420) from the one magnetometer (S_{k,l}), and wherein selecting a location (136) of the one balancing magnetic source (400) includes selecting an orientation of the one balancing magnetic source (400).

8. The method (100) of claim 7, wherein the magnetic field strength and the position of the one balancing magnetic source (400) is selected such that a ratio of its magnetic field strength to the distance (420) in the third exponent equals a corresponding ratio of the disturbing magnetic source (520), and particularly, wherein the orientation of the one balancing magnetic source (400) is selected substantially opposite to an orientation of the disturbing magnetic source (520).

9. The method (100) of claim 5, wherein one balancing magnetic source (400) is selected for each magnetometer (S_{k,l}) magnetically affected by the detected disturbing magnetic source (520).

10. The method (100) of any of the preceding claims, wherein at least one of the one or more selected balancing magnetic source (400) is mounted at or in a device body (530) of the electronic device (50).

11. An electronic device (50) for determining a location of at least one user-borne device (20) comprising at least one magnetic object (22), the electronic device (50) comprising:
a magnetometer sensing system (30) including at least one plurality of magnetometers (300),
at least one disturbing magnetic source (520) configured to generate a magnetic field having a magnetic effect on at least one magnetometer (S_{k,l}) of the magnetometer sensing system (30), and
one or more balancing magnetic sources (400) being configured and arranged to reduce the magnetic effect on the at least one magnetometer (S_{k,l}),
wherein the magnetometer sensing system (30) is magnetically calibrated according to the method of any one of the preceding claims.

12. The electronic device (50) of claim 11, wherein the magnetometer sensing system (30) is configured to obtain magnetic field measurements which are indicative of a magnetic field associated with the at least one magnetic object (22).

13. The electronic device (50) of any one of claims 11 or 12, wherein at least one of the one or more balancing magnetic sources (400) is arranged at, specifically fixed to, the disturbing magnetic source (520).

14. A system (10) for determining a location of at least one user-borne device (20), comprising:
at least one user-borne device (20) comprising at least one magnetic object (22), wherein
the user borne device (20) is operable with respect to an interaction surface (210) of the system (10),
an electronic device (50) of any one of claims 11 to 13, wherein the magnetometer sensing system (30) is configured to obtain magnetic field measurements associated with the at least one magnetic object (22).

15. The system (10) of claim 14, wherein the system (10) is configured to track a movement of the at least one magnetic object (22) in at least five degrees of freedom.
